# EUROPEAN PATENT APPLICATION

(11) **EP 4 391 029 A1**
(43) Date of publication of application: **26.06.2024**
(21) Application number: 23216781.7
(22) Date of filing: 14.12.2023
(51) Int. Cl.: H01L 21/48, H01L 23/13, H01L 23/36, H01L 23/367, H01L 23/433, H01L 23/538, H01L 23/66, H03F 1/02, H03F 1/22, H03F 1/52, H03F 3/195, H05K 1/02

(54) **AMPLIFIER MODULES AND SYSTEMS WITH GROUND TERMINALS ADJACENT TO POWER AMPLIFIER DIE**

(30) Priority: 19.12.2022 US 202218067788
(71) Applicant: NXP USA, Inc., Austin TX 78735 (US)
(72) Inventor: Roberts, Jeffrey Spencer, 5656AG Eindhoven (NL); Wang, Lu, 5656AG Eindhoven (NL); Santos, Fernando A., 5656AG Eindhoven (NL)
(74) Representative: Hardingham, Christopher Mark

(57) **Abstract**

An amplifier module includes a module substrate with a mounting surface, and a thermal dissipation structure that extends through the module substrate. A ground contact of a power transistor die is coupled to a surface of the thermal dissipation structure. Encapsulant material covers the mounting surface of the module substrate and the power transistor die, and a surface of the encapsulant material defines a contact surface of the amplifier module. A ground terminal is embedded within the encapsulant material. The ground terminal has a proximal end coupled to the thermal dissipation structure, and a distal end exposed at the contact surface. The ground terminal is electrically coupled to the ground contact of the power transistor die through the thermal dissipation structure.

## Description

### TECHNICAL FIELD

Embodiments of the subject matter described herein relate generally to amplifier modules, and more particularly to amplifier modules that include power transistor dies.

### BACKGROUND

Wireless communication systems employ power amplifier modules for increasing the power of radio frequency (RF) signals. A power amplifier module includes a module substrate and amplifier circuitry coupled to a mounting surface of the module substrate. A typical module substrate also may include input and output (I/O) terminals on a bottom surface of the module (i.e., the surface opposite the module mounting surface), and conductive signal routing structures extending through and across the module substrate between the I/O terminals and bondpads at the mounting surface. Further one or more ground/thermal dissipation structures may extend through the module substrate between the mounting and bottom surfaces.

The amplifier circuitry often includes a power transistor die, which has at least one integrated power transistor with a bottom-side conductive ground layer. The bottom-side conductive ground layer of the power transistor die is directly connected to the surface(s) of the ground/thermal dissipation structure(s) that are exposed at the mounting surface of the module substrate. Along with functioning to remove heat from the power transistor die, the ground/thermal dissipation structure(s) may function to provide a ground reference to the power transistor die.

To convey RF signals between the module substrate and the power transistor die, electrical connections are made between the bondpads at the mounting surface of the module substrate and the I/O bondpads of the power transistor die. When the integrated power transistor is a field effect transistor (FET), the die's input bondpad connects to the gate terminal of the FET, and the die's output bondpad connects to the drain terminal of the FET. The source terminal of the FET is coupled through the die to the bottom-side, conductive ground layer, which in turn is connected to the ground/thermal dissipation structure(s) of the module substrate, as described above.

To integrate the above-described power amplifier module into a communication system, the module typically is coupled to a mounting surface of a system printed circuit board (PCB). More specifically, the module substrate bottom surface is connected to the top surface of the system PCB so that bottom-side module signal I/O terminals align with corresponding signal I/O pads on the PCB mounting surface. In addition, the module substrate is connected to the system PCB so that the module ground/thermal dissipation structure(s) contact a PCB heat spreader that extends through the system PCB. Accordingly, the combination of the module ground/thermal dissipation structure and the system PCB heat spreader may perform the dual function of providing a thermal pathway to remove heat generated by the power transistor die, and providing a ground reference to the power transistor die.

During operation, the power transistor amplifies input RF signals received through the transistor die input bondpad, and conveys the amplified RF signal to the transistor die output bondpad. All the while, heat generated by the power transistor die is dissipated through the ground/thermal dissipation structure(s) embedded in the module substrate and through the system PCB heat spreader, and a ground reference also is provided through the ground/thermal dissipation structure(s) and the system PCB heat spreader.

The above-described configuration works well for many applications. However, other applications may require a different configuration in which a thermal path for the heat produced by the power transistor die extends in a direction away from the system PCB, rather than through the system PCB. Such different configurations generate new challenges, however, including challenges associated with providing an adequate ground reference for the power transistor die.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a schematic depiction of a Doherty power amplifier in a power amplifier module;
FIG. 2 is a top view of a power amplifier module that embodies the Doherty power amplifier of FIG. 1, in accordance with an example embodiment;
FIG. 3 is a cross-sectional, side view of the power amplifier module of FIG. 2 along line 3-3, in accordance with an example embodiment;
FIG. 4 includes cross-sectional side and top views of an embodiment of a ground terminal interposer, in accordance with an example embodiment;
FIG. 5 is a cross-sectional, side view of an alternate embodiment of the power amplifier module of FIG. 2 along line 3-3;
FIG. 6 is an exterior view of a contact surface of a power amplifier module that embodies the Doherty power amplifier of FIG. 1, in accordance with an example embodiment;
FIG. 7 is a cross-sectional, side view of an amplifier system that includes the power amplifier module of FIG. 2 coupled to a heat sink and an embodiment of a system substrate;
FIG. 8 is a cross-sectional, side view of an amplifier system that includes the power amplifier module of FIG. 2 coupled to a heat sink and an alternate embodiment of a system substrate; and
FIG. 9 is a flowchart of a method for fabricating a power amplifier module and an amplifier system, in accordance with an example embodiment.

### DETAILED DESCRIPTION

Embodiments of the inventive subject matter described herein include amplifier systems with a system substrate (e.g., a printed circuit board (PCB)) and a power amplifier module coupled to the system substrate. The power amplifier module includes a module substrate with an embedded heat dissipation structure, and a power amplifier die connected to the embedded heat dissipation structure. The power amplifier module is mounted to the system substrate in a "flipped orientation" with the embedded heat dissipation structure facing away from the system substrate, in contrast with conventional systems in which the embedded heat dissipation structure is coupled to a heat spreader in the system substrate. Accordingly, in an embodiment, a heat sink may be connected directly to the exposed surface of the embedded heat dissipation structure of the power amplifier module.

In such a system, proper grounding of the power amplifier die to the system substrate is important to achieve good performance. It is known that current (DC or RF) must travel in a closed loop. "Return current" is defined as the current flowing through a ground plane back to the source of the current. Current always takes the path that has the lowest "hurdle". For pure DC current, for example, that hurdle is resistance. In contrast, RF current tends to take the least inductive path. At higher frequencies, RF return current path optimization plays a significant role in power amplifier performance. More specifically, the return current path for the power amplifier die should be relatively short (in electrical length) to avoid significant reductions in efficiency, gain, stability or other performance metrics. As will be described in detail below, various embodiments of power amplifier modules are disclosed herein, which have grounding structures that provide a suitable ground/return current path for a power amplifier die of a power amplifier module that is mounted to a system PCB in a flipped orientation, as described above.

The power amplifier module embodiments described herein may be utilized to implement any of a variety of different types of power amplifiers. To provide a concrete example that will help to convey the details of the inventive subject matter, an example of a Doherty power amplifier module is utilized herein. However, those of skill in the art will understand, based on the description herein, that the inventive subject matter may be utilized in power amplifier modules that implement other types of amplifiers, as well. Accordingly, the use of a Doherty power amplifier in the example embodiments below is not meant to limit application of the inventive subject matter only to Doherty power amplifier modules, as the inventive subject matter may be used in other types of power amplifier modules, as well.

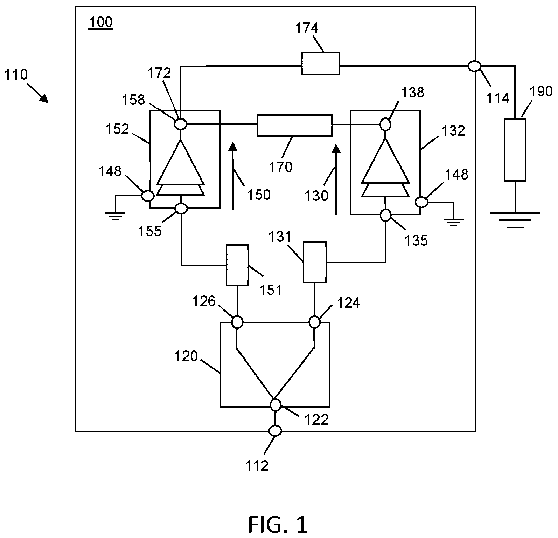

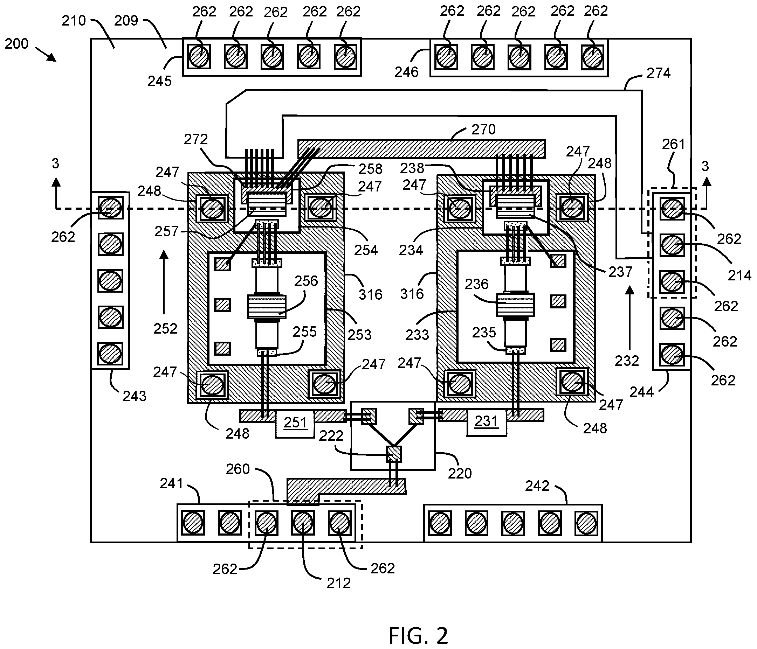

Prior to describing various physical implementations of power amplifier modules, reference is made to FIG. 1, which is a schematic depiction of a Doherty power amplifier 110 implemented in a power amplifier module 100. Power amplifier module 100 essentially includes a Doherty amplifier 110 implemented on a module substrate (e.g., module substrate 210, FIG. 2). Doherty amplifier 110 includes an RF input node 112, an RF output node 114, a power splitter 120, a carrier amplifier path 130 with one or more carrier amplifier dies (e.g., dies 233, 234, FIG. 2), a peaking amplifier path 150 with one or more peaking amplifiers (e.g., dies 253, 254, FIG. 2), a phase delay and impedance inversion element 170, and a combining node 172, in an embodiment. In addition, as will be discussed in more detail below, power amplifier module 100 also includes one or more ground terminals 148, which are configured to provide an external ground reference to the power amplifier dies of the carrier and peaking amplifier paths 130, 150, according to various embodiments. As will be described in more detail below, the ground terminals 148 are positioned in close proximity to the power amplifier dies in order to optimize the ground return loops for the dies, in accordance with various embodiments.

When incorporated into a larger RF system, the RF input node 112 is coupled to an RF signal source, and the RF output node 114 is coupled to a load 190 (e.g., an antenna or other load). The RF signal source provides an input RF signal, which is an analog signal that includes spectral energy that typically is centered around one or more carrier frequencies. Fundamentally, the Doherty amplifier 110 is configured to amplify the input RF signal, and to produce an amplified RF signal at the RF output node 114.

The power splitter 120 has an input 122 and two outputs 124, 126, in an embodiment. The power splitter input 122 is coupled to the RF input node 112 to receive the input RF signal. The power splitter 120 is configured to divide the RF input signal received at input 122 into first and second RF signals (or carrier and peaking signals), which are provided to the carrier and peaking amplifier paths 130, 150 through outputs 124, 126. According to an embodiment, the power splitter 120 includes a first phase shift element, which is configured to impart a first phase shift (e.g., about a 90 degree phase shift) to the peaking signal before it is provided to output 126. Accordingly, at outputs 124 and 126, the carrier and peaking signals may be about 90 degrees out of phase from each other.

When Doherty amplifier 110 has a symmetrical configuration (i.e., a configuration in which the carrier and peaking amplifier power transistors are substantially identical in size), the power splitter 120 may divide or split the input RF signal received at the input 122 into two signals that are very similar with, in some embodiments, equal power. Conversely, when Doherty amplifier 110 has an asymmetrical configuration (i.e., a configuration in which one of the amplifier power transistors, typically the peaking amplifier transistor, is significantly larger), the power splitter 120 may output carrier and peaking signals having unequal power.

The outputs 124, 126 of the power splitter 120 are connected to the carrier and peaking amplifier paths 130, 150, respectively. The carrier amplifier path 130 is configured to amplify the carrier signal from the power splitter 120, and to provide the amplified carrier signal to the power combining node 172. Similarly, the peaking amplifier path 150 is configured to amplify the peaking signal from the power splitter 120, and to provide the amplified peaking signal to the power combining node 172. The paths 130, 150 are designed so that the amplified carrier and peaking signals arrive in phase with each other at the power combining node 172.

According to an embodiment, the carrier amplifier path 130 includes an input circuit 131 (e.g., including an impedance matching circuit), a carrier amplifier 132 implemented using one or more carrier amplifier dies (e.g., dies 233, 234, FIG. 2), and a phase shift and impedance inversion element 170.

The carrier amplifier 132 includes an RF input terminal 135, an RF output terminal 138, and one or more amplification stages coupled between the input and output terminals 135, 138, in various embodiments. The RF input terminal 135 is coupled through input circuit 131 to the first output 124 of the power splitter 120, and thus the RF input terminal 135 receives the carrier signal produced by the power splitter 120.

Each amplification stage of the carrier amplifier 132 includes a power transistor. In a single-stage carrier amplifier 132, a single power transistor may be implemented on a single power amplifier die. In a two-stage carrier amplifier 132, two power transistors may be implemented on a single power amplifier die, or each power amplifier may be implemented on a separate die (e.g., dies 233, 234, FIG. 2), as will be exemplified in the power amplifier module depicted in FIG. 2.

Either way, each power transistor includes a control terminal (e.g., a gate terminal) and first and second current-carrying terminals (e.g., a drain terminal and a source terminal). In a single-stage device, which would include a single power transistor, the control terminal is electrically connected to the RF input terminal 135, one of the current-carrying terminals (e.g., the drain terminal) is electrically connected to the RF output terminal 138, and the other current-carrying terminal (e.g., the source terminal) is electrically connected to a ground reference (or another voltage reference). Conversely, a two-stage amplifier would include two power transistors coupled in series, where a first transistor functions as a driver amplifier transistor that has a relatively low gain, and a second transistor functions as a final-stage amplifier transistor that has a relatively high gain. In such an embodiment, the control terminal of the driver amplifier transistor is electrically connected to the RF input terminal 135, one of the current-carrying terminals of the driver amplifier transistor (e.g., the drain terminal) may be electrically connected to the control terminal of the final-stage amplifier transistor, and the other current-carrying terminal of the driver amplifier transistor (e.g., the source terminal) is electrically connected through an embodiment of a specialized ground terminal 148 to the ground reference (or another voltage reference). Additionally, one of the current-carrying terminals of the final-stage amplifier transistor (e.g., the drain terminal) is electrically connected to the RF output terminal 138, and the other current-carrying terminal of the final-stage amplifier transistor (e.g., the source terminal) may be electrically connected through an embodiment of a specialized ground terminal 148 to the ground reference (or another voltage reference). As will be explained in more detail in conjunction with FIGs 2-5, the electrical connection of the carrier amplifier driver and/or final-stage amplifier transistors to the ground reference may be made using specialized "interior" ground terminals that are positioned close to the carrier amplifier transistors to provide a relatively short ground return path for the carrier amplifier.

In addition to the power transistor(s), portions of input and output impedance matching networks and bias circuitry (not illustrated in FIG. 1) also may be included within the carrier amplifier 132 and/or electrically coupled to the carrier amplifier 132. Further, in an embodiment in which the carrier amplifier 132 is a two-stage device, an interstage matching network (not illustrated in FIG. 1) also may be included within the carrier amplifier 132 between the driver and final-stage amplifier transistors.

The RF output terminal 138 of the carrier amplifier 132 is coupled to the power combining node 172 through phase shift and impedance inversion element 170, in an embodiment. According to an embodiment, the impedance inversion element is a lambda/4 (λ/4) transmission line phase shift element (e.g., a microstrip line), which imparts about a 90 degree relative phase shift to the carrier signal after amplification by the carrier amplifier 132. A first end of the impedance inversion element 170 is coupled to the RF output terminal 138 of the carrier amplifier 132, and a second end of the phase shift element 170 is coupled to the power combining node 172.

Reference is now made to the peaking amplifier path 150, which includes a peaking amplifier 152 and an input circuit 151 (e.g., including an impedance matching circuit), in an embodiment. The peaking amplifier 152 includes an RF input terminal 155, an RF output terminal 158, and one or more amplification stages coupled between the input and output terminals 155, 158, in various embodiments. The RF input terminal 155 is coupled to the second output 126 of the power splitter 120, and thus the RF input terminal 155 receives the peaking signal produced by the power splitter 120.

As with the carrier amplifier 132, each amplification stage of the peaking amplifier 152 includes a power transistor with a control terminal and first and second current-carrying terminals. The power transistor(s) of the peaking amplifier 152 may be electrically coupled between the RF input and output terminals 155, 158 in a manner similar to that described above in conjunction with the description of the carrier amplifier 132. Additional other details discussed with in conjunction with the description of the carrier amplifier 132 also apply to the peaking amplifier 152, and those additional details are not reiterated here for brevity. However, one important point to reiterate is that a current-carrying terminal of each peaking amplifier transistor (e.g., the source terminal of a driver and/or final-stage peaking amplifier transistor) may be electrically connected through an embodiment of a specialized ground terminal 148 to the ground reference (or another voltage reference), as described above in conjunction with the description of the carrier amplifier 132. As will be explained in more detail in conjunction with FIGs 2-5, the electrical connection of the peaking amplifier driver and/or final-stage amplifier transistors to the ground reference may be made using the above-referenced, specialized interior ground terminals that are positioned close to the peaking amplifier transistors to provide a relatively short ground return path for the peaking amplifier.

The RF output terminal 158 of the peaking amplifier 152 is coupled to the power combining node 172. According to an embodiment, the RF output terminal 158 of the peaking amplifier 152 and the combining node 172 are implemented with a common element. More specifically, in an embodiment, the RF output terminal 158 of the peaking amplifier 152 is configured to function both as the combining node 172 and as the output terminal 158 of the peaking amplifier 152. To facilitate combination of the amplified carrier and peaking signals, and as mentioned above, the RF output terminal 158 (and thus the combining node 172) is connected to the second end of the phase shift and impedance inversion element 170. In other embodiments, the combining node 172 may be a separate element from the RF output terminal 158.

Either way, the amplified carrier and peaking RF signals combine in phase at the combining node 172. The combining node 172 is electrically coupled to the RF output node 114 to provide the amplified and combined RF output signal to the RF output node 114. In an embodiment, an output impedance matching network 174 between the combining node 172 and the RF output node 114 functions to present proper load impedances to each of the carrier and peaking amplifier 132, 152. The resulting amplified RF output signal is produced at RF output node 114, to which an output load 190 (e.g., an antenna) is connected.

Amplifier 110 is configured so that the carrier amplifier path 130 provides amplification for relatively low level input signals, and both amplification paths 130, 150 operate in combination to provide amplification for relatively high level input signals. This may be accomplished, for example, by biasing the carrier amplifier 132 so that the carrier amplifier 132 operates in a class AB mode, and biasing the peaking amplifier 152 so that the peaking amplifier 152 operates in a class C mode.

In the embodiment illustrated in FIG. 1 and described above, a first phase shift element in splitter 120 imparts about 90 degrees of phase shift to the peaking signal prior to amplification, and phase shift and impedance inversion element 170 similarly imparts about 90 degrees of phase shift to the amplified carrier signal so that the amplified carrier and peaking signals may combine in phase at the combining node 172. Such an architecture is referred to as a noninverted Doherty amplifier architecture. In an alternate embodiment, a first phase shift element in splitter 120 may impart about 90 degrees of phase shift to the carrier signal prior to amplification, rather than to the peaking signal, and phase shift and impedance inversion element 170 may be included instead at the output of the peaking amplifier. Such an alternate architecture is referred to as an inverted Doherty amplifier architecture. In still other alternate embodiments, other combinations of phase shift elements may be implemented in the carrier and/or peaking paths 130, 150 prior to amplification to achieve about 90 degrees of phase difference between the carrier and peaking signals prior to amplification, and the phase shifts applied to the amplified carrier and peaking signals may be selected accordingly to ensure that the signals combine in phase at combining node 172.

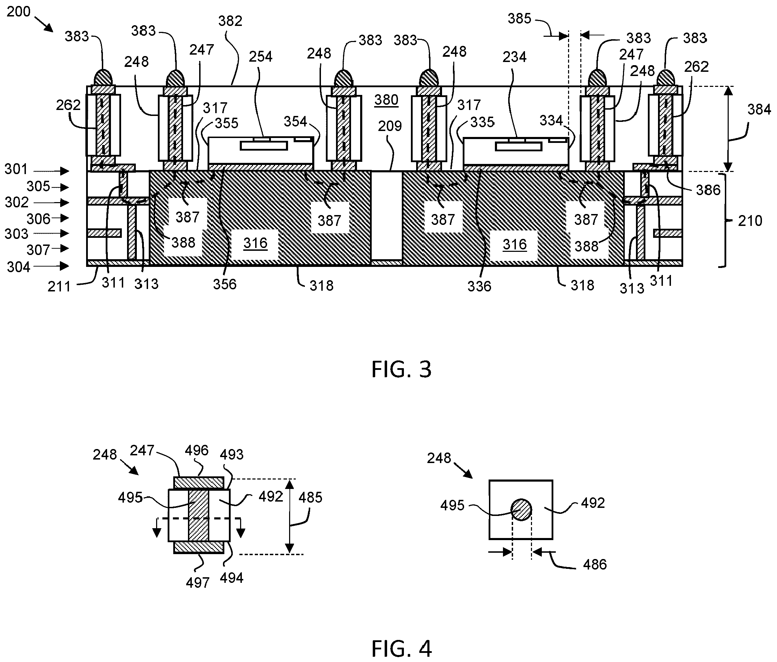

FIG. 2 is a top view of a power amplifier module 200 that embodies the Doherty amplifier circuitry of FIG. 1, in accordance with an example embodiment. To enhance understanding, FIG. 2 should be viewed simultaneously with FIG. 3, which is a cross-sectional, side view of the module 200 of FIG. 2 along line 3-3. Essentially, power amplifier module 200 includes a Doherty power amplifier (e.g., power amplifier 110, FIG. 1) implemented with a multi-layer module substrate 210 and a plurality of power transistor dies 233, 234, 253, 254 and other electrical components. Various components of power amplifier module 200 correspond with components depicted in FIG. 1, and it should be noted that corresponding components between FIG. 1 and FIGs 2-3 have the same last two numerical digits (e.g., components 120 and 220 are corresponding components).

Power amplifier module 200 includes a module substrate 210 in the form of a multiple-layer printed circuit board (PCB) or other suitable substrate. The module substrate 210 has a top surface 209 (also referred to as a "mounting surface") and a bottom surface 211 (also referred to as a "heat sink attachment surface"). As will be described in more detail below, a plurality of components and terminals are coupled to the mounting surface 209 of the module substrate 210, and non-conductive encapsulant material 380 (e.g., a plastic encapsulant) is disposed on the mounting surface 209 and over the components and terminals to define a top surface 382 (also referred to as a "contact surface") of the module 200. As shown in FIG. 3, the encapsulant material 380 has a thickness 384 that is greater than the maximum height of the components (e.g., splitter 220 and power transistor dies 233, 234, 253, 254) covered by the encapsulant material 380.

As depicted in FIG. 3, the module substrate 210 includes a plurality of dielectric layers 305, 306, 307 (e.g., formed from FR-4, ceramic, or other PCB dielectric materials), in an alternating arrangement with a plurality of conductive layers 301, 302, 303, 304, where a top surface 209 of the module substrate 210 is defined by a patterned conductive layer 301, and a bottom surface 211 of the module substrate 210 is defined by a conductive layer 304. It should be noted that, although module substrate 210 is shown to include three dielectric layers 305-307 and four conductive layers 301-304, other embodiments of a module substrate may include more or fewer dielectric layers and/or conductive layers.

Each of the various conductive layers 301-304 may have a primary purpose, and also may include conductive features that facilitate signal and/or voltage/ground routing between other layers. Although the description below indicates a primary purpose for each of the conductive layers 301-304, it should be understood that the layers (or their functionality) may be arranged differently from the particular arrangement best illustrated in FIG. 3 and discussed below.

For example, in an embodiment, the patterned conductive layer 301 at the mounting surface 209 of the module substrate 210 may primarily function as a signal conducting layer. More specifically, layer 301 includes a plurality of conductive features (e.g., conductive pads and traces) which serve as attachment points for various discrete components, and also provide electrical connectivity between the dies 233, 234, 253, 254 and the other discrete components. In addition, as will be discussed below, layer 301 may include a plurality of conductive pads that are specifically designated for attachment of electrically conductive signal and/or ground terminals, which will be described in more detail later.

A second patterned conductive layer 302 functions as an RF ground layer. The RF ground layer 302 also includes a plurality of conductive features (e.g., conductive traces), which may be electrically coupled to conductive features of the signal conducting layer 301 and to a system ground layer 304 (described below) with conductive vias (e.g., vias 311, 313) that extend through the dielectric layers 305-307. In addition, the RF ground layer 302 may contact thermal dissipation structures 316, described below.

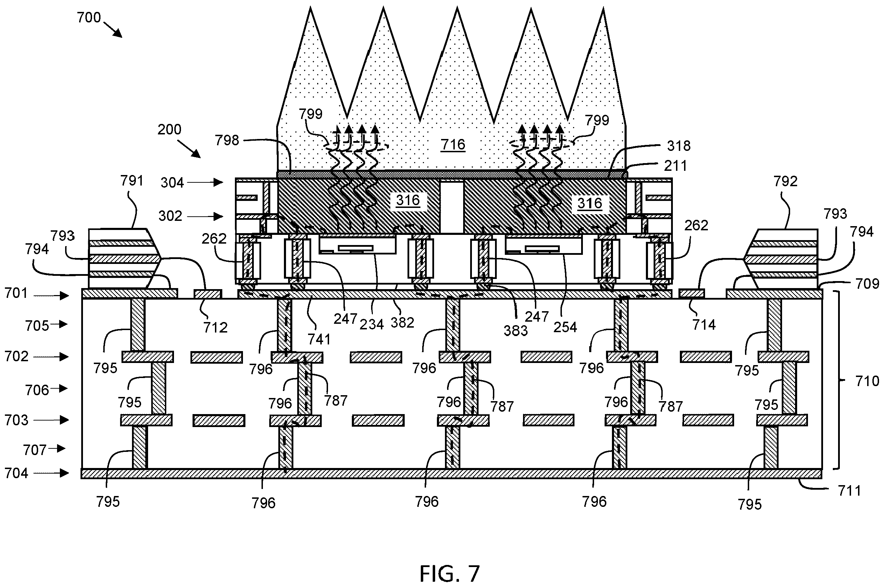

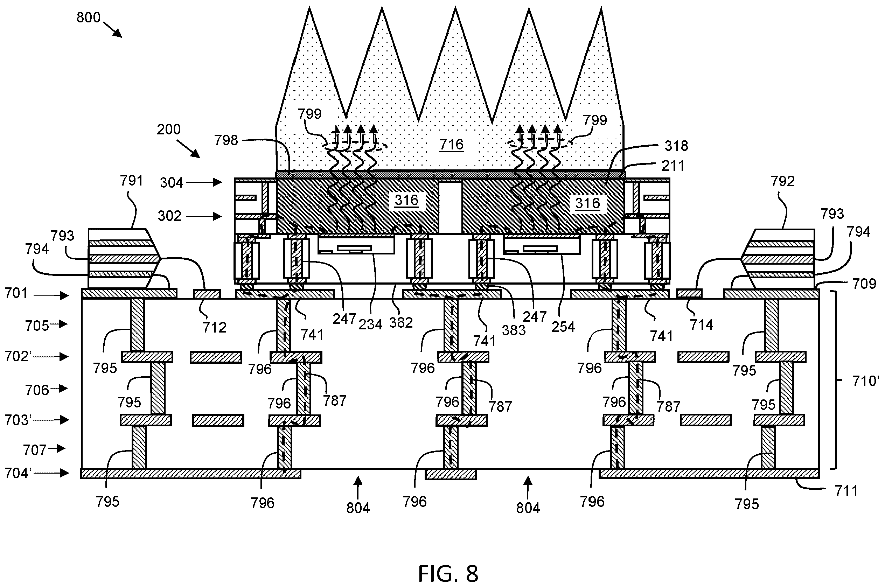

A third patterned conductive layer 303 functions to convey bias voltages to power transistors 236, 237, 256, 257 within the dies 233, 234, 253, 254, and also may function as a routing layer, as mentioned above. Finally, a fourth conductive layer 304 functions as a system ground layer and also as a heat sink attachment layer, as will be explained in more detail in conjunction with FIGs 7, 8.

According to an embodiment, module substrate 210 also includes one or more thermal dissipation structures 316, which extend between the top and bottom surfaces 209, 211 of the module substrate 210. The dies 233, 234, 253, 254 are physically and electrically coupled to surfaces 317 of the thermal dissipation structures 316 that are exposed at the top surface 209 of the module substrate 210. The bottom surfaces 318 of the thermal dissipation structures 316 may be exposed at the bottom surface 211 of the module substrate 210, as shown in FIG. 3, or the bottom surfaces 318 of the thermal dissipation structures 316 may be covered with the bottom conductive layer 304. Either way, the thermal dissipation structures 316 are configured to provide a thermal pathway between the dies 233, 234, 253, 254 and the bottom surfaces 318 of the thermal dissipation structures 316 (and thus the bottom surface 211 of the module substrate 210).

In various embodiments, the thermal dissipation structures 316 may include electrically and thermally conductive metallic coins that are press-fit and/or attached into through-holes that extend between the surfaces 209, 211 of the module substrate 210. As will be described in more detail in conjunction with FIGs 7, 8, the surfaces 318 of the thermal dissipation structures 316 (or the portion of the conductive layer 304 overlying those surfaces 318) are physically and thermally coupled to a heat sink (e.g., heat sink 716, FIGs 7, 8) when the module 200 is integrated within a larger electrical system.

According to various embodiments, electrically-conductive interior ground terminals 247 are connected directly to the upper surfaces 317 of the thermal dissipation structures 316. More specifically, lower or proximal surfaces of the interior ground terminals 247 are connected to the thermal dissipation structures 316, and upper or distal surfaces of the interior ground terminals 247 are exposed at the contact surface 382 of the module 200. The proximal surfaces of the interior ground terminals 247 may be attached to the thermal dissipation structures 316 using solder, conductive adhesive, sintering, brazing, or other suitable materials and methods.

Desirably, the interior ground terminals 247 are connected to the thermal dissipation structures 316 "in close proximity" to one or more sides of one or more of the power transistor dies 233, 234, 253, 254 (e.g., in close proximity to sides 334, 335, 354, 355 of dies 234, 254, as shown in FIG. 3). As used herein, the phrase "in close proximity", in the above context, means that a physical distance (e.g., distance 385, FIG. 3) between a side (e.g., side 334, FIG. 3) of a power transistor die (e.g., die 234) and a side of a ground terminal (e.g., ground terminal 247) is less than half the width of the die to which the ground terminal is adjacent. In addition or alternatively, the phrase "in close proximity", in the above context, means that an electrical length of an electrically conductive path (e.g., dashed-line path 387) between the ground contact for the die (e.g., the bottom-side source contact 336) through the thermal dissipation structure (e.g., structure 316) and the height of the ground terminal (e.g., terminal 247) is less than about lambda/5 (λ/5), in some embodiments, or less than about lambda/16 (λ/16), in other embodiments.

Although FIG. 2 illustrates the interior ground terminals 247 having been positioned at specific locations on the thermal dissipation structures 316, the interior ground terminals 247 may be positioned at additional and/or different locations, as well. More specifically, it is desirable that the interior ground terminals 247 be positioned so that their ultimate effect may be to minimize or substantially eliminate the RF return current spreading across the module substrate 210, which may otherwise have peak current areas similar to standing waves.

According to a further embodiment, each of the interior ground terminals 247 may be embedded within a ground terminal interposer 248. Referring briefly to FIG. 4, two cross-sectional views of an example ground terminal interposer 248 are shown. As shown in the side, cross-sectional view (drawing on the left side of FIG. 4), the ground terminal interposer 248 includes a dielectric body 492 (e.g., formed from FR-4, ceramic, or other suitable dielectric materials) with top and bottom surfaces 493, 494, and a conductive via 495 extending through the dielectric body 492 between its top and bottom surfaces 493, 494. In addition, conductive pads 496, 497 are deposited on the top and bottom surfaces 493, 494 in contact with first and second ends, respectively, of the conductive via 495. The top-down, cross-sectional view (drawing on the right side of FIG. 4) shows that the conductive via 495 may have a circular cross-sectional shape. However, in other embodiments, the conductive via 495 alternatively may have a square, rectangular, or bar shape. Either way, the ground terminal interposer 248 provides a conductive path between pads 496, 497 through via 495. Each interior ground terminal 247 comprises pads 496, 497 and a via 495.

When the via 495 has a square or circular cross-section, the via 495 may have a width 486 (or diameter) in a range of about 200 microns to about 800 microns (e.g., about 500 microns), although the width 486 may be smaller or larger, as well. The height 485 of the ground terminal interposer 248 may be in a range of about 500 microns to about 1500 microns (e.g., about 1000 microns), for example, although the ground terminal interposer 248 may be shorter or taller, as well. According to an embodiment, the height 485 of the ground terminal interposer 248 may be approximately equal to the thickness 384 of the encapsulant material 380 (FIG. 3), so that the top conductive pad 496 of each ground terminal interposer 248 may be substantially co-planar with the contact surface 382 of the module 200. In other embodiments, the top conductive pad 496 of each ground terminal interposer 248 may be recessed below or extend above the contact surface 382 of the module 200. Either way, the top conductive pad 496 of each ground terminal interposer 248 is exposed at the contact surface 382.

Referring again to FIG. 2, the power amplifier module 200 further includes an RF signal input terminal 212 (e.g., RF input node 112, FIG. 1), a power splitter 220 (e.g., power splitter 120, FIG. 1), a two-stage, carrier amplifier 232 (e.g., amplifier 132, FIG. 1), a two-stage peaking amplifier 252 (e.g., amplifier 152, FIG. 1), various phase shift and impedance matching elements, a combining node 272 (e.g., combining node 172, FIG. 1), an output impedance matching network 274 (e.g., network 174, FIG. 1), and an RF signal output terminal 214 (e.g., RF output node 114, FIG. 1).

The RF signal input and output terminals 212, 214, along with additional peripheral ground terminals 262 and bias terminals (not numbered), are embedded within multi-terminal interposers 241, 242, 243, 244, 245, 246, in an embodiment. Each of the multi-terminal interposers 241-246 is similarly constructed to the example ground terminal interposer 248 shown in FIG. 4, except that each of the multi-terminal interposers 241-246 includes multiple terminals embedded within a dielectric body, rather than just a single terminal. According to an embodiment, the proximal end of each of the multiple terminals embedded within each multi-terminal interposer 241-246 is electrically coupled (e.g., soldered) to a conductive terminal pad (e.g., pad 386) at the mounting surface 209 of the module substrate 210 (e.g., a conductive pad formed from a portion of conductive layer 301). Some of the conductive terminal pads are electrically coupled through additional conductive traces (e.g., traces formed from additional portions of conductive layer 301) to the components embedded within the module 200. Other ones of the conductive terminal pads (e.g., pad 386), and specifically those pads that are coupled to the additional peripheral ground terminals 262, may be coupled to the RF ground layer 302. Accordingly, such pads 386 also are electrically coupled to the thermal dissipation structures 316.

As mentioned previously, the interior ground terminals 247 provide first electrically conductive paths (e.g., dashed-line path 387, FIG. 3) between the ground contact for a die (e.g., the bottom-side source contacts 336, 356) and the contact surface 382 of the module 200. The peripheral ground terminals 262 provide additional electrically conductive paths (e.g., dashed-line path 388, FIG. 3) between the ground contact for the die (e.g., the bottom-side source contact 336) through the thermal dissipation structure (e.g., structure 316), RF ground layer 302, via 311, and the height of the peripheral ground terminal (e.g., terminal 262). As can be seen in FIG. 3, the length of the ground path through the interior ground terminals 247 to the contact surface 382 (i.e., path 387) is significantly shorter than the length of the ground path through the peripheral ground terminals 262 to the contact surface 382 (i.e., path 388).

Including the interior ground terminals 247, in accordance with various embodiments, may provide several advantages, in comparison with modules that do not include such terminals. For example, the interior ground terminals 247 may enable a more even distribution of the ground currents from the transistors 233, 234, 253, 254. Further, the interior ground terminals 247 may eliminate electromagnetic (EM) feedback loops at certain frequencies. Directly coupling the interior ground terminals 247 to the thermal dissipation structures 316 also may reduce source inductance and allow for better EM isolation between the output, input, and interstages of the Doherty amplifier with little or no increase in layout space, since the interior ground terminals 247 may be placed in otherwise unused spaces on the thermal dissipation structures 316. Further still, reducing the length of the return current path may improve the small signal stability margin. This may be particularly beneficial during operation in low temperature environments in which the stability margin tends to worsen as the ambient temperature drops (e.g., below -40 degrees Celsius).

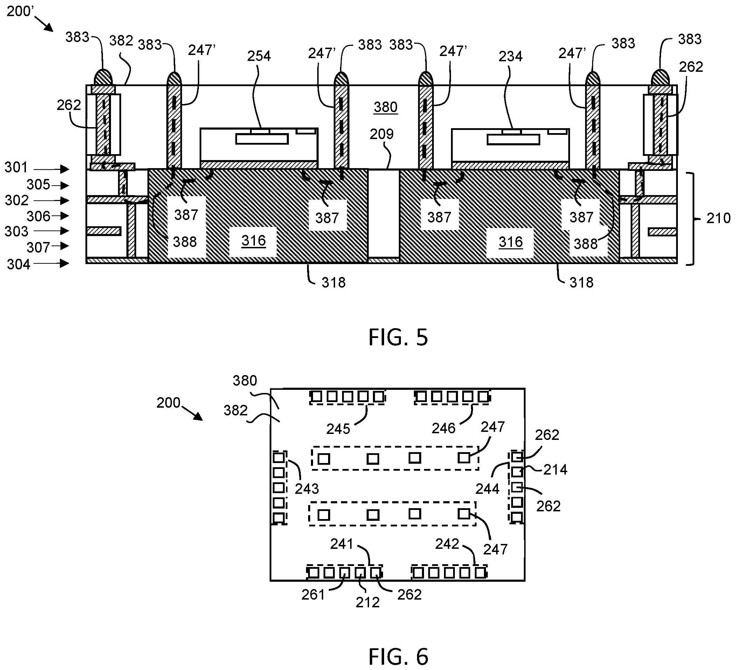

In the embodiment illustrated in FIGs 2 and 3, each of the interior ground terminals 247 are embedded within a ground terminal interposer 248. In an alternate embodiment of module 200' shown in the cross-sectional view of FIG. 5, each interior ground terminal 247' instead may be implemented as a simple conductive pillar or a conductive via that extends through encapsulation material 380, rather than being embedded within a ground terminal interposer 248. In such an embodiment, a proximal end of each interior ground terminal 247' is directly coupled to a surface 317 of a thermal dissipation structure 316, and a distal end of each interior ground terminal 247' is exposed at the contact surface 382 of the module 200'. The conductive pillars for the interior ground terminals 247' may be formed from a highly conductive material, such as copper or another suitable conductive metal. The pillars may be pre-formed and, prior to applying the encapsulation material 380, the pillars may be attached to the thermal dissipation structures 316 using solder, conductive adhesive, sintering, brazing, or other suitable materials and methods.

Terminal 212 functions as the RF signal input terminal for the module 200, and is coupled to an RF signal input pad at the top surface 209 of the module substrate 210 (e.g., a conductive pad formed from a portion of conductive layer 301). Through one or more conductive structures (e.g., traces and/or wirebonds, as shown), the RF signal input pad is electrically coupled to an input 222 to the power splitter 220. According to an embodiment, terminal 212 is embedded within terminal interposer 241, and additional ground terminals 262, 262 on either side of terminal 212 also are embedded within terminal interposer 241 in order to provide a GSG (ground-signal-ground) terminal structure 260.

The power splitter 220, which is coupled to the mounting surface 209 of the system substrate 210, may include one or more discrete die and/or components, although it is represented in FIG. 2 as a single element. The power splitter 220 includes an input terminal 222 and two output terminals (not numbered, but corresponding to terminals 124, 126, FIG. 1). The input terminal 222 is electrically coupled through one or more conductive structures (e.g., traces and/or wirebonds, as shown) to the RF signal input pad and to the RF signal input terminal 212, and thus is configured to receive an input RF signal. The output terminals of the power splitter 220 are electrically coupled through one or more conductive structures (e.g., vias, traces, and/or wirebonds) and input circuits 231, 251 (e.g., input circuits 131, 151, FIG. 1) to inputs 235, 255 for the carrier and peaking amplifiers 232, 252, respectively.

The power splitter 220 is configured to split the power of the input RF signal received through the RF input terminal 212 into first and second RF signals, which are produced at the output terminals of the power splitter 220. In addition, the power splitter 220 may include one or more phase shift elements configured to impart about a 90 degree phase difference between the RF signals provided at the splitter output terminals. The first and second RF signals produced at the outputs of the power splitter 220 may have equal or unequal power, as described previously.

The first output of the power splitter is electrically coupled to a carrier amplifier path (i.e., to the carrier amplifier 232), and the second output of the power splitter is electrically coupled to a peaking amplifier path (i.e., to the peaking amplifier 252). The RF signal produced at the second power splitter output may be delayed by about 90 degrees from the RF signal produced at the first power splitter output. In other words, the RF signal provided to the peaking amplifier path may be delayed by about 90 degrees from the RF signal provided to the carrier amplifier path. In any event, the first RF signal produced by the power splitter 220 is amplified through the carrier amplifier path 232, and the second RF signal produced by the power splitter 220 is amplified through the peaking amplifier path 252.

In the specific embodiment of FIG. 2, each of the carrier and peaking amplifier paths includes a two-stage power amplifier 232, 252, where a driver amplifier transistor 236, 256 is implemented on a driver amplifier die 233, 253, and a final-stage amplifier transistor 237, 257 is implemented on a separate final-stage amplifier die 234, 254. For example, each of the transistors 236, 237, 256, 257 may be field effect transistors (FETs), such as laterally-diffused metal oxide semiconductor (LDMOS) FETs or high electron mobility transistors (HEMTs). The description and claims may refer to each transistor as including a control terminal and two current-conducting terminals. For example, using terminology associated with FETs, a "control terminal" refers to a gate terminal of a transistor, and first and second current-conducting terminals refer to drain and source terminals (or vice versa) of a transistor. Although the below description may use terminology commonly used in conjunction with FET devices, the various embodiments are not limited to implementations the utilize FET devices, and instead are meant to apply also to implementations that utilize bipolar junction transistors (BJT) devices or other suitable types of transistors.

The carrier amplifier 232 more specifically includes a silicon driver stage die 233 and a gallium nitride (GaN) final-stage die 234, and the peaking amplifier 252 also includes a silicon driver stage die 253 and a GaN final-stage die 254, in accordance with an example embodiment. In other embodiments, each of the carrier and peaking amplifiers 232, 252 may include a two-stage power amplifier implemented on a single die, or each of the carrier and peaking amplifiers 232, 252 may include a single-stage power amplifier implemented on a single die. In still other embodiments, each of the carrier and peaking amplifiers may include a two-stage power amplifier implemented on separate driver and final-stage dies, but the driver and final-stage dies may be formed using the same semiconductor technology (e.g., both the driver and final-stage dies are silicon dies or GaN dies), or the driver and/or final-stage dies may be formed using different semiconductor technologies than those described above (e.g., the driver and/or final-stage dies may be formed from silicon germanium (SiGe) and/or gallium arsenide (GaAs)).

The carrier amplifier path includes the above-mentioned driver stage die 233, the final-stage die 234, and a phase shift and impedance inversion element 270 (e.g., element 170, FIG. 1). The driver stage die 233 and the final-stage die 234 of the carrier amplifier path 232 are electrically coupled together in a cascade arrangement between an input terminal 235 of the driver stage die 233 (corresponding to a carrier amplifier input) and an output terminal 238 of the final-stage die 234 (corresponding to a carrier amplifier output).

The driver stage die 233 includes a plurality of integrated circuits. In an embodiment, the integrated circuitry of die 233 includes a series-coupled arrangement of the input terminal 235 (e.g., input terminal 135, FIG. 1), an input impedance matching circuit (not numbered), a silicon power transistor 236, an integrated portion of an interstage impedance matching circuit (not numbered), and an output terminal not numbered, in an embodiment. More specifically, the gate of the transistor 236 is electrically coupled through the input impedance matching circuit to the input terminal 235, and the drain of the transistor 236 is electrically coupled through the output impedance matching circuit to the output terminal of die 233. The source of transistor 236 is electrically coupled to a conductive layer (or source terminal, similar to source contact 336, FIG. 3) on a bottom surface of die 233, and the bottom conductive layer is physically, electrically, and thermally coupled to the exposed top surface 317 of a thermal dissipation structure 316.

The output terminal of the driver stage die 233 is electrically coupled to the input terminal of the final-stage die 234 through a wirebond array (not numbered) or another type of electrical connection. The final-stage die 234 also includes a plurality of integrated circuits. In an embodiment, the integrated circuitry of die 234 includes a series-coupled arrangement of an input terminal (not numbered), a GaN power transistor 237, and an output terminal 238 (e.g., output terminal 138, FIG. 1). More specifically, the gate of the transistor 237 is electrically coupled to the input terminal of die 234, and the drain of the transistor 237 is electrically coupled to the output terminal 238 of die 234. The source of transistor 237 is electrically coupled to a conductive layer 336 on a bottom surface of die 234, and the bottom conductive layer 336 is physically, electrically, and thermally coupled to the exposed top surface 317 of a thermal dissipation structure 316.

The peaking amplifier path includes the above-mentioned driver stage die 253 and the final-stage die 254. The driver stage die 253 and the final-stage die 254 of the peaking amplifier path 252 are electrically coupled together in a cascade arrangement between an input terminal 255 of the driver stage die 253 (corresponding to a peaking amplifier input) and an output terminal 258 of the final-stage die 254 (corresponding to a peaking amplifier output).

The driver stage die 253 includes a plurality of integrated circuits. In an embodiment, the integrated circuitry of die 253 includes a series-coupled arrangement of the input terminal 255 (e.g., input terminal 155, FIG. 1), an input impedance matching circuit (not numbered), a silicon power transistor 256, an integrated portion of an interstage impedance matching circuit (not numbered), and an output terminal (not numbered), in an embodiment. More specifically, the gate of the transistor 256 is electrically coupled through the input impedance matching circuit to the input terminal 255, and the drain of the transistor 256 is electrically coupled through the output impedance matching circuit to the output terminal of die 253. The source of transistor 256 is electrically coupled to a conductive layer (or source terminal, similar to source contact 356, FIG. 3) on a bottom surface of die 253, and the bottom conductive layer is physically, electrically, and thermally coupled to the exposed top surface of a thermal dissipation structure 316.

The output terminal of the driver stage die 253 is electrically coupled to the input terminal of the final-stage die 254 through a wirebond array (not numbered) or another type of electrical connection. The final-stage die 254 also includes a plurality of integrated circuits. In an embodiment, the integrated circuitry of die 254 includes a series-coupled arrangement of an input terminal (not numbered), a GaN power transistor 257, and an output terminal 258 (e.g., output terminal 158, FIG. 1). More specifically, the gate of the transistor 257 is electrically coupled to the input terminal of die 254, and the drain of the transistor 257 is electrically coupled to the output terminal 258 of die 254. The source of transistor 257 is electrically coupled to a conductive layer 356 on a bottom surface of die 254, and the bottom conductive layer 356 is physically, electrically, and thermally coupled to the exposed top surface of a thermal dissipation structure 316.

An amplified carrier signal is produced at the output terminal 238 of the final-stage die 234, and an amplified peaking signal is produced at the output terminal 258 of the final-stage die 254, which also functions as the combining node 272 (e.g., node 172, FIG. 1) for the amplifier. According to an embodiment, the output terminal 238 of the carrier final-stage die 234 is electrically coupled (e.g., through wirebonds (not numbered) or another type of electrical connection) to a first end of the phase shift and impedance inversion element 270, and a second end of the phase shift and impedance inversion element 270 is electrically coupled (e.g., through wirebonds (not numbered) or another type of electrical connection) to the output terminal 258 of the peaking final-stage die 254, and thus to the combining node 272.

According to an embodiment, the phase shift and impedance inversion element 270 may be implemented with a quarter-wavelength or lambda/4 (λ/4) or shorter transmission line (e.g., a microstrip transmission line with an electrical length up to about 90 degrees) that is formed from a portion of the conductive layer 301. As used herein, lambda is the wavelength of an RF signal at the fundamental frequency of operation of the amplifier (e.g., a frequency in a range of about 600 megahertz (MHz) to about 10 gigahertz (GHz) or higher). The combination of the phase shift and impedance inversion element 270 and the wirebond (or other) connections to the output terminals 238, 258 of dies 234, 254 may impart about a 90 degree relative phase shift to the amplified carrier signal as the signal travels from output terminal 238 to output terminal 258/combining node 272. When the various phase shifts imparted separately on the carrier and peaking RF signals through the carrier and peaking paths, respectively, are substantially equal, the amplified carrier and peaking RF signals combine substantially in phase at output terminal 258/combining node 272.

The output terminal 258/combining node 272 is electrically coupled (e.g., through wirebonds or another type of electrical connection) through an output impedance matching network 274 (e.g., network 174, FIG. 1) to RF output terminal 214 (e.g., node 114, FIG. 1). The output impedance matching network 274 functions to present the proper load impedances to each of carrier and peaking final-stage dies 234, 254. Although shown in a highly simplified form in FIG. 2, the output impedance matching network 274 may include various conductive traces, additional discrete components (e.g., capacitors, inductors, and/or resistors) between output terminal 258/combining node 272 and RF output terminal 214, which provide the desired impedance matching. According to an embodiment, the RF output terminal 214 is embedded within terminal interposer 244, and additional ground terminals 262, 262 on either side of terminal 214 also are embedded within terminal interposer 244 in order to provide a GSG (ground-signal-ground) terminal structure 261.

FIG. 6 is an exterior view of the contact surface 382 of power amplifier module 200, in accordance with an example embodiment. As is apparent from FIG. 6, module 200 includes a plurality of terminals at the periphery of the contact surface 382 (e.g., terminals 212, 214, 262), and a plurality of interior ground terminals 247 nearer to the center of the contact surface 382. Referring also to FIGs 3 and 5, conductive attachment material 383 (e.g., solder balls, solder paste, or conductive adhesive) is disposed on the exposed distal surfaces of the interior ground terminals 247 (or 247', FIG. 5), the input and output terminals 212, 214, the additional peripheral ground terminals 262, and any other terminals. The conductive attachment material 383 on the distal ends of the various terminals 212, 214, 247, 262 enables the module 200 to be physically and electrically connected to a system substrate (e.g., system substrate 710, 710', FIGs 7, 8), and thus to be electrically connected to a larger electrical system (e.g., a final stage amplifier of a cellular base station).

To incorporate embodiments of power amplifier module 200 into a larger electrical system, the terminals at the contact surface 382 of the power amplifier module 200 are physically and electrically coupled to a system substrate, and a heat sink is attached to the opposite surface of the power amplifier module 200. To illustrate the integration of power amplifier module 200 into such a system, reference is now made to FIG. 7, which is a cross-sectional, side view of an amplifier system 700 that includes the power amplifier module 200 of FIG. 2 coupled to an embodiment of a system substrate 710 and a heat sink 716, in accordance with an example embodiment. As will be explained in more detail below, system 700 has a "closed ground" configuration, in which the system substrate 710 has a ground plane layer 704 underlying an entirety of the power amplifier module 200.

The RF system 700 generally includes a system substrate 710, power amplifier module 200 (or module 200'), and a heat sink 716. According to an embodiment, the system substrate 710 includes a multi-layer printed circuit board (PCB) or other suitable substrate. The system substrate 710 has a top surface 709 (also referred to as a "mounting surface"), an opposed bottom surface 711. As depicted in FIG. 7, the system substrate 710 includes a plurality of dielectric layers 705, 706, 707 (e.g., formed from FR-4, ceramic, or other PCB dielectric materials), in an alternating arrangement with a plurality of conductive layers 701, 702, 703, 704, where the top surface 709 of the system substrate 710 is defined by a patterned conductive layer 701, and the bottom surface 711 of the system substrate 710 is defined by conductive "back metal" layer 704. It should be noted that, although system substrate 710 is shown to include three dielectric layers 705-607 and four conductive layers 701-704, other embodiments of a system substrate may include more or fewer dielectric layers and/or conductive layers.

Each of the various conductive layers 701-704 may have a primary purpose, and also may include conductive features that facilitate signal and/or voltage/ground routing between other layers. Although the description below indicates a primary purpose for some of the conductive layers 701-704, it should be understood that the layers (or their functionality) may be arranged differently from the particular arrangement best illustrated in FIG. 7 and discussed below.

For example, in an embodiment, the patterned conductive layer 701 at the mounting surface 709 of the system substrate 710 may primarily function as a signal conducting layer and an attachment layer for the interior and peripheral ground terminals 247, 262. More specifically, layer 701 includes a plurality of conductive features (e.g., conductive pads and traces) which serve as attachment points for module 200, an input RF connector 791, and an output RF connector 792. Each of RF connectors 791, 792 may, for example, be coaxial connectors with a central signal conductor 793 and an outer ground shield 794. According to an embodiment, the signal conductor 793 of RF input connector 791 is electrically coupled to a first conductive trace 712 of layer 701, which in turn is coupled to input terminal 212 of module 200. In addition, the signal conductor 793 of RF output connector 792 is electrically coupled to a second conductive trace 714 of layer 701, which in turn is coupled to an output terminal (e.g., terminal 214, FIG. 2) of module 200. The ground shields 794 of connectors 791, 792 are electrically coupled to additional traces (not numbered), which in turn are electrically coupled to a system ground layer 704 of the system substrate 710 through one or more conductive vias 795 that extend between layers 701 and 704.

As just indicated, conductive layer 704 functions as a system ground layer. In addition to being electrically coupled to the ground shields 794 of connectors 791, 792, the system ground layer 704 also is electrically coupled through additional conductive vias 796 to an additional ground pad 741 on the mounting surface 709. As will be described in more detail below, the additional ground pad 741 is physically and electrically coupled to the various ground terminals (e.g., terminals 247, 262) of module 200. System substrate 710 configures system 700 as a "closed ground" system, in that the ground pad 741 and the system ground layer 704 each comprises a continuous, solid conductive layer. The ground pad 741 is a solid conductive layer with a rectangular perimeter that encompasses all of the interior ground terminals 247. The ground pad 741 also may have extensions, as shown in FIG. 7, that enable the ground pad 741 to contact the peripheral ground terminals 262. The ground pad 741 does not underly or contact the RF signal input or output terminals 212, 214 or other terminals configured to carry bias voltages or information-bearing signals. The system ground layer 704 underlies the entire module 200, in an embodiment.

Module 200 (or module 200') is coupled to the mounting surface 709 of system substrate 710 in an inverted (or "flipped") orientation from the orientations depicted in FIGs 3 and 5. More specifically, module 200 is coupled to the system substrate 710 so that the contact surface 382 of the module 200 and the mounting surface 709 of the system substrate 710 face each other. In order to connect module 200 to system substrate 710, each of the terminals of module 200 (e.g., terminals 212, 214, 247, 262, FIG. 2) are aligned and brought into contact with corresponding pads (e.g., pads 712, 714, 741) on the mounting surface 709 of system substrate 710. In embodiments in which conductive attachment material 383 is disposed on the exposed ends of the module terminals, the conductive attachment material 383 is reflowed or otherwise cured to physically connect the module terminals to their corresponding pads on the mounting surface 709 of the module substrate 710. In other embodiments, conductive attachment material also or alternatively may be disposed on the conductive pads (e.g., pad 741) of the system substrate 710, and an appropriate reflow or curing process may be performed to connect the module 200 to the system substrate 710.

According to an embodiment, a heat sink 716 is physically and thermally coupled to the heat sink attachment surface 211 of the power amplifier module 200, and more specifically to conductive layer 304 and/or the surfaces 318 of the embedded heat dissipation structures 316 of module 200. The heat sink 716 is formed from a thermally-conductive material, which also may be electrically-conductive. For example, the heat sink 716 may be formed from copper or another bulk conductive material. To couple the heat sink 716 to the power amplifier module 200, a thermally conductive material 798 (e.g., thermal grease) may be dispensed on the heat sink attachment surface 211 of the module 200 (and/or on the surfaces 318 of the heat dissipation structures 316) and/or the heat sink 716, and the heat sink 716 may be brought into contact with the heat sink attachment surface 211. The heat sink 716 may then be clamped, screwed, or otherwise secured in place.

During operation of RF system 700, input RF signals are provided through the RF input terminal 791 and trace/pad 712 to an RF input terminal 212 (FIG. 2) at the contact surface 382 of the power amplifier module 200. The input RF signals are conveyed through terminal 212 and additional components (e.g., power splitter 220, FIG. 2) to the power transistor dies 233, 234, 253, 254, which amplify the input RF signal as discussed previously. The amplified output RF signals are produced at output terminal 214 (FIGs 2, 5A, 5B, 5C), which is electrically coupled to trace/pad 714, and to the RF output terminal 792.

According to an embodiment, a ground path is provided between each of the power transistor dies 233, 234, 253, 254 and the system ground layer 704. For example, for dies 234, 254 shown in FIG. 7, the ground path for each die 234, 254 includes a first conductive ground path (e.g., ground path 387, FIGs 3, 5), which extends from the ground contact for the die (e.g., the bottom-side source contact 336, 356, FIGs 3, 5) through a portion of the thermal dissipation structure 316, In addition, the ground path for each die 234, 254 includes a second conductive ground path (e.g., ground path 388, FIGs 3, 5) through a portion of the thermal dissipation structure 316, the RF ground layer 302 of the module 200, any intervening vias (e.g., vias 311), a ground terminal pad (e.g., pads 386), and one or more peripheral ground terminals (e.g., terminals 262). As shown in FIG. 7 with dashed-line paths 787, the ground path continues through the ground pad 741 on the mounting surface 709 of the system substrate 710 and one or more ground vias 796 to the system ground layer 704.

As discussed in detail previously, the interior ground terminals 247 (or 247') of the module 200 (or module 200') are connected to the thermal dissipation structures 316 in close proximity to the power transistor dies 233, 234, 253, 254, which results in a relatively short ground return path for the module 200. Desirably, the entire electrical length of the ground path between the ground contact 336 for each die 233, 234, 253, 254 and the system ground layer 704 is less than about lambda/5 (λ/5), in some embodiments, or less than about lambda/16 (λ/16), in other embodiments.

During operation, significant thermal energy (heat) may be produced by the power transistor(s) within the power transistor dies 233, 234, 253, 254. As indicated by arrows 799, the thermal energy produced by the power transistor(s) is conveyed through the thermal dissipation structures 316 to the heat sink 716, which effectively dissipates the heat to the ambient atmosphere. Accordingly, the thermal dissipation structures 316 provides two functions: 1) the function of conveying heat produced by the power transistor dies 233, 234, 253, 254 to the heat sink 716; and 2) the function of electrically coupling the ground contacts 336 of the dies 233, 234, 253, 254 to system ground.

FIG. 8 is a cross-sectional, side view of an amplifier system 800 that includes the power amplifier module 200 of FIG. 2 coupled to a heat sink 716 and an alternate embodiment of a system substrate 710'. System 800 is essentially identical to system 700, and all of the above details are incorporated into this description of system 800, except that the system substrate 710' has some differences that configure system 800 as an "open ground" system. More particularly, in substrate 710' the system ground layer 704' includes a plurality of openings 804 directly below the mounted module 200. Further, the intervening conductive layers 702', 703' also have eliminated conductive material between the module 200 and the system ground layer 704. The effect of the removal of the conductive features in layers 702', 703', and 704' essentially results in moving the system ground plane further away from the mounting surface 382 of the module 200. This may result in a reduction or elimination of certain out-of-band instabilities

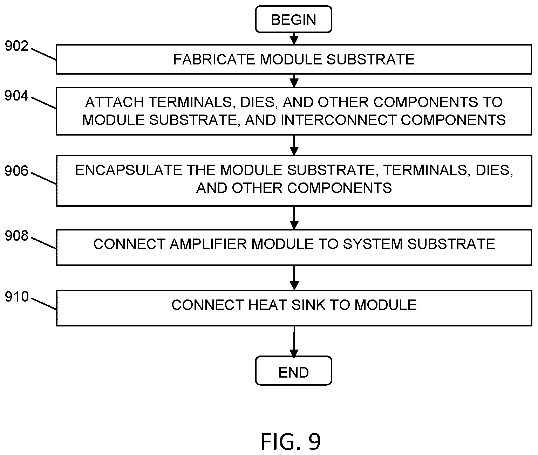

FIG. 9 is a flowchart of a method of fabricating a power amplifier module (e.g., power amplifier module 200, 200', FIGs 2, 3, 5) and assembling the power amplifier module into an RF system (e.g., RF system 700, 800, FIGs 7, 8), in accordance with an example embodiment. The method may begin, in block 902 ("Fabricate module substrate"), by fabricating a multi-layer module substrate (e.g., module substrate 210, FIGs 2, 3, 5) using known techniques. As discussed previously, a plurality of pads and traces are formed from portions of a patterned conductive layer (e.g., layer 301, FIGs 3, 5) at a mounting surface of the module substrate. In block 904 ("Attach terminals, Dies, and other components to module substrate, and interconnect components"), various peripheral terminals (e.g., terminals 212, 214, 262, FIGs 2, 3, 5) and/or peripheral terminal interposers (e.g., interposers 241-246), power transistor dies (e.g., dies 233, 234, 253, 254, FIG. 2), and other components (e.g., power splitter 220, FIG. 2) are connected to the mounting surface of the module substrate. In addition, interior ground terminals (e.g., terminals 247, 247', FIGs 2, 3, 5) and/or ground terminal interposers (e.g., interposers 248) are connected to the thermal dissipation structure(s) (e.g., structures 316), which are embedded within the module substrate. Additional connections (e.g., wirebonds) are made between the power transistor dies and components. In some embodiments, the interior ground terminals and/or their associated ground terminal interposers may be connected to the thermal dissipation structure(s) simultaneously with connecting the peripheral terminals and dies (i.e., before wirebonding to the dies), while in other embodiments, the interior ground terminals and/or their associated ground terminal interposers may be connected to the thermal dissipation structure(s) after connecting the peripheral terminals and dies, and after wirebonding to form connections to the dies.

In block 906 ("Encapsulate the module substrate, terminal, dies and other components"), the module substrate, terminals, dies, and other components are encapsulated (e.g., with encapsulant material 380, FIG. 3), to define a contact surface 382 at which distal ends of the terminals are exposed. In block 908 ("Connect Amplifier module to system substrate"), the module 200 is inverted, and the module terminals are aligned with and brought into contact with corresponding pads (e.g., pads 741, FIGs 7, 8) on the mounting surface of a system substrate (e.g., system substrate 710, 710', FIGs 7, 8). Conductive attachment material (e.g., material 383, such as solder or conductive adhesive) is reflowed, cured, or otherwise processed to produce a mechanical and electrical connection between the module terminals and the system substrate pads. This establishes signal and ground paths between the module and the system substrate.

Finally, in block 910 ("Connect heat sink to module"), a heat sink (e.g., heat sink 716, FIGs 7, 8) is attached to the heat sink attachment surface (e.g., surface 211, FIGs 3, 5) of the module substrate. For example, the heat sink may be attached to the module substrate using a thermally conductive material (e.g., material 798 (FIGs 7, 8), such as thermal grease), clamps, screws, and/or other attachment means. The method then ends.

An embodiment of an amplifier module includes a module substrate, a thermal dissipation structure, a power transistor die, encapsulant material, and an interior ground terminal. The thermal dissipation structure extends through the module substrate. The thermal dissipation structure has a first surface and a second surface, and the first surface is exposed at a mounting surface of the module substrate. The power transistor die has a ground contact, which is coupled to the first surface of the thermal dissipation structure. The encapsulant material covers the mounting surface of the module substrate and the power transistor die, and a surface of the encapsulant material defines a contact surface of the amplifier module. The interior ground terminal is embedded within the encapsulant material, and the interior ground terminal has a proximal end connected to the thermal dissipation structure, and a distal end exposed at the contact surface. The interior ground terminal is electrically coupled to the ground contact of the power transistor die through the thermal dissipation structure.
An embodiment of an amplifier system includes a system substrate and an amplifier module. The system substrate has a mounting surface, a first signal conducting layer, a first ground layer, and a ground pad at the first mounting surface. The ground pad is electrically coupled to the first ground layer. The amplifier module has a contact surface and a heat sink attachment surface, and the amplifier module is coupled to the system substrate with the mounting surface of the system substrate facing the contact surface of the amplifier module. The amplifier module further includes a module substrate, a thermal dissipation structure, a power transistor die, encapsulant material, and an interior ground terminal. The thermal dissipation structure extends through the module substrate. The thermal dissipation structure has a first surface and a second surface, and the first surface is exposed at the mounting surface of the module substrate. The power transistor die has a ground contact, which is coupled to the first surface of the thermal dissipation structure. The encapsulant material covers the mounting surface of the module substrate and the power transistor die, and a surface of the encapsulant material defines the contact surface of the amplifier module. The interior ground terminal is embedded within the encapsulant material, and the interior ground terminal has a proximal end connected to the thermal dissipation structure, and a distal end exposed at the contact surface. The interior ground terminal is electrically coupled to the ground contact of the power transistor die through the thermal dissipation structure. In one or more embodiments, the distal end of the interior ground terminal is coupled to the ground pad of the system substrate. The amplifier system may further comprise: a heat sink coupled to the heat sink attachment surface. The first interior ground terminal may be connected to the first thermal dissipation structure in close proximity to a first side of the first power transistor die.

An embodiment of a method of fabricating a power amplifier includes coupling a power transistor die to a thermal dissipation structure that extends through a module substrate, where the module substrate has a mounting surface, a first surface of the thermal dissipation structure is exposed at the mounting surface of the module substrate, and the power transistor die has a ground contact that is connected to the first surface of the thermal dissipation structure. The method further includes coupling a proximal end of an interior ground terminal to the thermal dissipation structure, and covering the mounting surface of the module substrate and the power transistor die with an encapsulant material to form an amplifier module. A surface of the encapsulant material defines a contact surface of the amplifier module, a distal end of the interior ground terminal is exposed at the contact surface, and the interior ground terminal is electrically coupled to the ground contact of the power transistor die through the thermal dissipation structure.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. An amplifier module comprising:
a module substrate with a mounting surface;
a first thermal dissipation structure extending through the module substrate, wherein the first thermal dissipation structure has a first surface and a second surface, wherein the first surface is exposed at the mounting surface of the module substrate;
a first power transistor die with a first ground contact, wherein the first ground contact is coupled to the first surface of the first thermal dissipation structure;
encapsulant material covering the mounting surface of the module substrate and the first power transistor die, wherein a surface of the encapsulant material defines a contact surface of the amplifier module; and
a first interior ground terminal embedded within the encapsulant material, wherein the first interior ground terminal has a proximal end connected to the first thermal dissipation structure, and a distal end exposed at the contact surface, and wherein the first interior ground terminal is electrically coupled to the first ground contact of the first power transistor die through the first thermal dissipation structure.

2. The amplifier module of claim 1, wherein the first thermal dissipation structure includes a metallic coin embedded in the module substrate.

3. The amplifier module of claim 1 or 2, wherein the first interior ground terminal comprises a conductive pillar.

4. The amplifier module of any preceding claim, further comprising:
an interposer terminal that includes a dielectric body with a top surface and a bottom surface, and a conductive via extending between the top and bottom surfaces of the dielectric body, wherein the conductive via corresponds to the first interior ground terminal.

5. The amplifier module of claim 4, wherein the first interposer terminal further comprises:
a first conductive pad on the top surface of the dielectric body and connected to a first end of the conductive via, wherein the first conductive pad corresponds to the distal end of the first interior ground terminal; and
a second conductive pad on the bottom surface of the dielectric body and connected to a second end of the conductive via, wherein the second conductive pad corresponds to the proximal end of the first interior ground terminal.

6. The amplifier module of any preceding claim, wherein the first interior ground terminal is connected to the first thermal dissipation structure in close proximity to a first side of the first power transistor die.

7. The amplifier module of claim 6, wherein a distance between the first power transistor die and the first interior ground terminal is less than half a width of the first power transistor die.

8. The amplifier module of claim 6 or 7, further comprising:
a second interior ground terminal connected to the first thermal dissipation structure in close proximity to a second side of the first power transistor die.

9. The amplifier module of any preceding claim, further comprising:
a second thermal dissipation structure extending through the module substrate, wherein the second thermal dissipation structure has a first surface and a second surface, wherein the first surface is exposed at the mounting surface of the module substrate;
a second power transistor die with a second ground contact, wherein the second ground contact is coupled to the first surface of the second thermal dissipation structure; and
a second interior ground terminal embedded within the encapsulant material, wherein the second interior ground terminal has a proximal end connected to the second thermal dissipation structure, and a distal end exposed at the contact surface, and wherein the second interior ground terminal is electrically coupled to the second ground contact of the second power transistor die through the second thermal dissipation structure.

10. The amplifier module of claim 9, wherein:
the first power transistor die is a carrier amplifier die of a Doherty power amplifier;
the second power transistor die is a peaking amplifier die of a Doherty power amplifier; and
the amplifier module further includes a phase delay and impedance inversion element electrically connected between outputs of the first and second power transistor dies.

11. A method of fabricating a power amplifier, the method comprising:
coupling a power transistor die to a thermal dissipation structure that extends through a module substrate, wherein
the module substrate has a mounting surface,
a first surface of the thermal dissipation structure is exposed at the mounting surface of the module substrate, and
the power transistor die has a ground contact, wherein the ground contact is connected to the first surface of the thermal dissipation structure;
coupling a proximal end of an interior ground terminal to the thermal dissipation structure; and
covering the mounting surface of the module substrate and the power transistor die with an encapsulant material to form an amplifier module, wherein a surface of the encapsulant material defines a contact surface of the amplifier module, a distal end of the interior ground terminal is exposed at the contact surface, and the interior ground terminal is electrically coupled to the ground contact of the power transistor die through the thermal dissipation structure.

12. The method of claim 11, further comprising:
coupling the amplifier module to a system substrate with a mounting surface of the system substrate facing the contact surface of the amplifier module, wherein the system substrate further includes a second signal conducting layer, a second ground layer, and a ground pad, wherein the ground pad is electrically coupled to the second ground layer, and wherein the distal end of the interior ground terminal is coupled to the ground pad.

13. The method of claim 11 or 12, wherein the amplifier module has a heat sink attachment surface opposite the contact surface, and the method further comprises:
coupling a heat sink to the heat sink attachment surface of the amplifier module.

14. The method of any one of claims 11 to 13, wherein the interior ground terminal is connected to the thermal dissipation structure in close proximity to a first side of the power transistor die.
